# EUROPÄISCHE PATENTSCHRIFT

(11) **EP 2 740 577 B1**
(45) Veröffentlichungstag und Bekanntmachung des Hinweises auf die Patenterteilung: **14.10.2015**
(21) Anmeldenummer: 12195623.9
(22) Anmeldetag: 05.12.2012
(51) Int. Cl.: B29C 70/46, B29D 99/00, C04B 28/26, F28F 21/04, H01L 23/367, H01L 21/48

(54) **Verfahren zur Herstellung eines Formteils**
Method for producing a moulded part
Procédé de fabrication d'un élément de formage

(43) Veröffentlichungstag der Anmeldung: 11.06.2014
(73) Patentinhaber: Zehnder Group International AG, 5722 Gränichen (CH); Kleiner, Wolfgang, 8266 Steckborn (CH); Götz, Thomas, 8266 Steckborn (CH)
(72) Erfinder: Götz Thomas, 8266 Steckborn (CH); Kleiner Wolfgang, 8266 Steckborn (CH)
(74) Vertreter: Stenger Watzke Ring

(56) Entgegenhaltungen:
- EP-A1- 0 004 882
- EP-A1- 0 028 341
- EP-A1- 0 524 403
- CH-A- 479 043
- CN-A- 1 560 287
- DE-A1- 2 636 430
- DE-A1- 4 204 583
- DE-A1- 4 411 436
- DE-A1- 10 310 803
- DE-A1- 19 651 721
- DE-B- 1 025 107
- DE-C- 576 509
- DE-C- 691 507
- DE-C- 727 872
- DE-C- 758 959
- GB-A- 168 025

## Beschreibung

Die Erfindung betrifft ein Verfahren zur Herstellung eines Formteils, insbesondere eines plattenförmigen Formteils.

Die Herstellung von Formteilen im Allgemeinen sowie von plattenförmigen Formteilen im Speziellen ist aus dem Stand der Technik an sich bekannt. Eines besonderen druckschriftlichen Nachweises bedarf es an dieser Stelle deshalb nicht.

Die Einsatz- und Verwendungsgebiete von Formteilen, auch von solchen in plattenförmiger Ausgestaltung sind zahlreich, weshalb es bezogen auf den jeweiligen Anwendungsfall unterschiedliche Anforderungen seitens der Formteile zu erfüllen gilt, was sich auch im Herstellungsverfahren niederschlägt. So sind aus dem Stand der Technik beispielsweise Formteile aus Kunststoff oder anderen gieß- oder stampf- oder pressbaren Materialien bekannt geworden, die zur Strukturverstärkung Gitternetze aus z.B. Metall-oder Glasfasern aufweisen. Aufgrund ihrer Materialkombination können derlei Formteile unterschiedlichen Anforderungen in der Verwendung gleichermaßen gerecht werden.

Obgleich Formteile sowie Verfahren zu deren Herstellung in vielerlei Ausgestaltungsformen aus dem Stand der Technik bekannt sind, besteht ein ständiges Bestreben nach weiter optimierten Herstellverfahren und/oder Formteilen. Nicht zuletzt spielt der Umweltschutz in diesem Zusammenhang eine immer wichtigere Rolle.

In diesem Zusammenhang ist insbesondere aus der DE 196 51 721 A1 ein Verfahren zur Herstellung eines Formkörpers aus metallhaltigem Abfallkonglomerat bekannt geworden.

Hierbei werden metallhaltige Abfallstoffe, wie zum Beispiel Metallspäne, durch Zusatz eines viskositätssteigernden Stoffes wie insbesondere Wasserglas zu Formkörpern verpresst. Besagte Formkörper werden alsdann der Materialrückgewinnung zugeführt.

Ferner offenbart die DE 103 10 803 A1 ein Wolframformteil für den Fischereibedarf. Dieser dient in erster Linie als Beschwerungskörper für Angeln. Zur Herstellung dieses Formteils wird Wolframpulver mit Wasserglas gemischt, in entsprechende Formen gegossen und anschließend getrocknet. Weitere Bestandteile des Formkörpers können unter anderem Metallspäne sein.

Darüber hinaus offenbart die EP 0 524 403 A1 ein Verfahren zur Herstellung einer mehrschichtigen Materialstruktur in Plattenform. Eine der mittleren Schichten kann hierbei aus Wasserglas und Kaolin (siliciumhaltiges Mineral) gebildet werden, wobei ein Glasfasergewebe mit besagter Masse getränkt wird. Anstelle des Glasfasergewebes können auch Röhrenstrukturen eingepresst werden. Diese bleiben allerdings hinsichtlich ihrer mechanischen Eigenschaften hinter denen des Glasfasergewebes zurück.

Es ist deshalb die Aufgabe der Erfindung, ein neuartiges Verfahren zur Herstellung eines Formteils vorzuschlagen, welches das Formteil für eine Vielzahl von Anwendungen nutzbar macht, ohne die mechanischen Eigenschaften des Formteils zu verschlechtern. Mit der Erfindung soll zudem ein neuartiges Formteil vorgeschlagen werden, welches über vergleichsweise gute mechanische Eigenschaften verfügt und für eine Vielzahl von Anwendungen nutzbar ist.

Verfahrensseitig wird zur Lösung dieser Aufgabe vorgeschlagen ein Verfahren zur Herstellung eines Formteils gemäß Anspruch 1.

Nach dem erfindungsgemäßen Verfahren dient zur Herstellung eines Formteils ein Kompositwerkstoff, d.h. ein Verbundwerkstoff. Bei diesem Kompositwerkstoff handelt es sich erfindungsgemäß um einen Metall-Kompositwerkstoff, der Metallspäne und Wasserglas beinhaltet. Dabei dient das Wasserglas als Klebstoff für die Metallspäne.

Zur Herstellung des Kompositwerkstoffes werden die Metallspäne und das Wasserglas in einem vorgebbaren Mischungsverhältnis miteinander vermischt. Zwischen den Metallspänen und dem Wasserglas kommt es zu einer Reaktion in Form einer Diffusionsverklebung, wobei eine Verklebung des Wasserglases mit den Oxidschichten der Metallspäne stattfindet. Das Metall-Komposit wird sodann in eine Pressform eingebracht und zu einem Formteil verpresst.

Im endfertig verpressten Zustand weist das Formteil durch die bei der Verpressung des Metall-Komposits erfolgte Verformung und Verkrallung der einzelnen Metallspäne eine Basisstruktur mit sehr hoher Festigkeit auf, die sich ergänzend zur schon vorbeschriebenen Diffusionsverklebung einstellt. Im Ergebnis ergeben sich so Formteile von hoher mechanischer Festigkeit bei gleichzeitig geringem Gewicht, die darüber hinaus mechanisch nachbearbeitet werden können, wie z.B. durch Drehen, Bohren, Fräsen und/oder dgl.

Die Verwendung einer Pressform gestattet es, auch vergleichsweise komplizierte Geometrien ausbilden zu können. Dies gestattet auch die Ausgestaltung passgenauer Formteile. Im einfachsten Fall wird die Pressform durch die Pressflächen einer Flächenpresse gebildet. Diese dient der Herstellung plattenförmiger Formteile, wobei es gestattet ist, plattenförmige Formteile unterschiedlicher Wandstärken herzustellen. Zu diesem Zweck wird eine entsprechende Menge an Metall-Komposit zwischen die Pressflächen der Flächenpresse eingebracht, und es erfolgt durch entsprechendes Verfahren der Pressenflächen ein Verpressen des Metall-Komposits zu einem plattenförmigen Formteil, d.h. einer Platte.

Von Vorteil der erfindungsgemäßen Verfahrensdurchführung ist im Übrigen, dass die Ausgangskomponenten zur Herstellung des Kompositwerkstoffes in ausreichender Menge verfügbar und vergleichsweise preiswert am Markt erhältlich sind. Sie enthalten keine giftigen oder sonst wie umweltbelastenden Substanzen. Es handelt sich um Werkstoffe auf sogenannter Sekundärrohstoffbasis. Insbesondere bei den Metallspänen kann es sich um Abfälle aus metallverarbeitenden Betrieben handeln, die auf diese Weise umweltschonend, d.h. ohne großen Energieaufwand durch Einschmelzen wieder verwendet werden können. Insofern zeichnet sich das erfindungsgemäße Verfahren durch seine Umweltfreundlichkeit aus.

Darüber hinaus ist das Verfahren vergleichsweise einfach in der Anwendung. Die Ausgangsstoffe des Kompositwerkstoffes können separat voneinander bevorratet werden. Zur Herstellung des Kompositwerkstoffes bedarf es lediglich einer Vermischung der Ausgangskomponenten. Anschließend findet eine Verpressung in einer aus dem Stand der Technik an sich bekannten Presse statt, und es steht im Ergebnis ein nach der erfindungsgemäßen Verfahrensdurchführung hergestelltes Formteil. Dieses kann dank einer entsprechenden Wahl hinsichtlich der verwendeten Ausgangskomponenten in unterschiedlichsten Anwendungsfällen zum Einsatz kommen.

Es ist gemäß einem weiteren Merkmal der Erfindung vorgesehen, dass als Metallspäne Späne unterschiedlicher Metalle verwendet werden. Auf diese Weise lässt sich auf die späteren Eigenschaften des nach dem Verfahren hergestellten Formteils gezielt Einfluss nehmen. So kann beispielsweise durch entsprechende Wahl der Menge und der Art der eingesetzten Metallspäne auf die spätere Festigkeit, Wärmeleitfähigkeit, elektrische Leitfähigkeit und/oder dgl. Eigenschaften des späteren Formteils Einfluss genommen werden.

Gemäß einem weiteren Merkmal der Erfindung ist vorgesehen, dass der Kompositwerkstoff unter Verwendung eines Zuschlagstoffes als weitere Ausgangskomponente hergestellt wird. Durch die Verwendung eines Zuschlagstoffes oder sogar mehrerer unterschiedlicher Zuschlagstoffe lassen sich die späteren Eigenschaften des nach dem Verfahren hergestellten Formteils ergänzend beeinflussen. Als ein Zuschlagstoff kommt insbesondere ein hochwärmeleitendes Material in Frage, wie beispielsweise Graphit oder Metallpulver. Es ist so gestattet, dem späteren Formteil eine hohe Wärmeleitfähigkeit zu verleihen, womit es geeignet ist, als Heiz- oder Kühlkörper bzw. als Heiz- oder Kühlkörperteil, als Baukomponente eines Wärmetauschers für Heizung, Kühlung und/oder Klimatisierung oder als Bauelement für den Bau von Wärmetauschern für gasförmige oder flüssige Medien verwendet zu werden. Es können auch andere Zuschlagstoffe gewählt werden, die das nach dem erfindungsgemäßen Verfahren hergestellte Formteil im Besonderen dafür befähigen, im Bauwesen eingesetzt zu werden, beispielsweise als Trägerplatte, Bodenbelag und/oder dgl.

Es ist gemäß einem weiteren Merkmal der Erfindung vorgesehen, dass die Metallspäne vor einer Herstellung des Kompositwerkstoffes zerkleinert werden. Es kann so gezielt auf die Größe der einzelnen Metallspäne Einfluss genommen werden. Auch hierdurch können die späteren Eigenschaften des nach dem erfindungsgemäßen Verfahren hergestellten Formteils gezielt beeinflusst werden.

Der Kompositwerkstoff wird gemäß einem weiteren Merkmal der Erfindung vor einer Verpressung homogenisiert. Diese Maßnahme dient dazu, eine gleichmäßige Verteilung der eingesetzten Ausgangskomponenten innerhalb des Kompositwerkstoffes zu erzielen, so dass das spätere Formteil eine möglichst vergleichmäßigte Eigenschaftsverteilung aufweist.

Es ist gemäß einem weiteren Merkmal der Erfindung vorgesehen, dass in den Kompositwerkstoff während des Verpressens Funktionselemente eingepresst werden. Bei derlei Funktionselementen kann es sich beispielsweise um Befestigungs- und/oder Verbindungselemente handeln, die im späteren Verwendungsfall des erfindungsgemäßen Formteils dazu dienen, Formteile miteinander und/oder mit anderen Baukomponenten dauerhaft sicher koppeln, d.h. verbinden zu können. Als derlei Funktionselemente kommen beispielsweise Haken, Ösen, Anbauteile und/oder dgl. in Frage.

In den Kompositwerkstoff werden erfindungsgemäß Funktionselemente ausgebildet als Rohre und/oder Rohrregister aus Metall oder Kunststoff eingebettet. Plattenförmige Formteile mit derart eingebetteten Funktionselementen können als Plattenwärmetauscher-Register oder als Heiz- oder Kühlkörper Verwendung finden. Aus derlei ausgerüsteten Formteilen können auch Wärmetauscher insbesondere, aber nicht nur, Luft-Luft-Wärmetauscher hergestellt werden. Es ist dabei bevorzugt, dass der Kompositwerkstoff Graphit als Zuschlagstoff enthält, der zum Ausfüllen lufthaltender Hohlräume im Kompositwerkstoff dient. Dabei wird im Zuge der erfindungsgemäßen Verfahrensdurchführung die gesamte Oberfläche des Graphits gleichermaßen mit Wasserglas als Klebstoff benetzt. Das Wasserglas wird somit mittelbar mit Graphitteilchen besetzt, um über Silikatbrücken eine Diffusionsverklebung mit den Metalloxiden der Metallspäne einzugehen.

In den Kompositwerkstoff können gemäß einem weiteren Merkmal der Erfindung während des Verpressens Vertiefungen eingepresst werden. Bei derlei Vertiefungen kann es sich beispielsweise um Nuten, Riffelungen und/oder sonstige Oberflächensturen handeln.

Vorrichtungsseitig wird zur Lösung der vorstehenden Aufgabe vorgeschlagen ein Formteil gemäß Anspruch 8.

Das erfindungsgemäße Formteil ist aus einem Kompositwerkstoff gebildet. Dieser Kompositwerkstoff enthält als Ausgangskomponenten Metallspäne und Wasserglas. Er ist durch Verpressen hergestellt. Im Ergebnis ergibt sich ein formstabiles Formteil mit hoher mechanischer Festigkeit bei gleichzeitig geringem Gewicht. Eine nachträglich mechanische Bearbeitung ist in vorteilhafter Weise gestattet, so dass je nach späterem Verwendungszweck umfangreiche Nachbearbeitungen stattfinden können.

Zur Ausbildung eines plattenförmigen Formteils kommen Flächenpressen, Walzenpressen bzw. Kalanderpressen zum Einsatz, in die der Kompositwerkstoff in entsprechender Menge einzubringen ist. In der Flächenpresse können Platten unterschiedlicher Stärke durch Verpressen hergestellt werden.

Je nach späteren Verwendungszweck können weitere Ausgangskomponenten zur Herstellung des Kompositwerkstoffes verwendet werden, so z.B. hochwärmeleitende Materialien, beispielsweise Graphit und/oder Metallpulver. Dabei kommen mit hochwärmeleitendem Material ausgerüstete Formteile vorzugsweise in der Heiz- oder Klimatechnik zum Einsatz, beispielsweise zur Ausgestaltung von Wärmetauschern, Heiz- und/oder Kühleinrichtungen.

Es lassen sich aber auch Formteile mit niedriger Wärmeleitfähigkeit herstellen, die dann beispielsweise in Form von Platten als Konstruktionsmaterial oder Baustoff im Maschinenbau oder im Gebäudebau Verwendung finden können.

In das Formteil können Funktionselemente und/oder Vertiefungen eingebracht sein. Als Funktionselemente kommen insbesondere Befestigungs- und/oder Verbindungselemente, zusätzliche Versteifungselemente und/oder erfindungsgemäß Rohre oder Rohrregister in Frage, die während des Verpressens des Kompositwerkstoffes in diesen eingebettet werden.

Im Übrigen ergeben sich hinsichtlich des erfindungsgemäßen Formteils die schon vorstehend anhand des erfindungsgemäßen Verfahrens beschriebenen Vorteile in entsprechender Weise.

Mit der Erfindung wird ferner die Verwendung eines Formteils, insbesondere eines plattenförmigen Formteils der eingangs genannten Art als Heiz- oder Kühlkörper vorgeschlagen.

Weitere Merkmale und Vorteile der Erfindung ergeben sich aus der nachfolgenden Beschreibung anhand der einzigen Figur, die in schematischer Darstellung die erfindungsgemäße Verfahrensdurchführung zeigt.

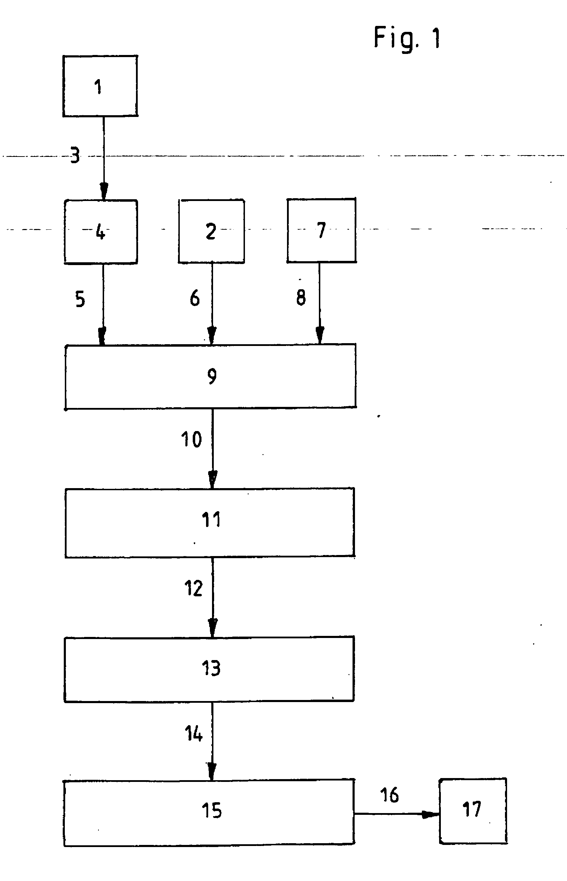

Fig. 1 lässt die erfindungsgemäße Verfahrensdurchführung anhand einer Blockdiagramm-Darstellung schematisch erkennen. Das erfindungsgemäße Formteil 17, das als Ergebnis der Verfahrensdurchführung steht, wird aus einem Kompositwerkstoff, d.h. einem Metallkompositwerkstoff hergestellt. Als Ausgangsstoffe für diesen Kompositwerkstoff dienen Metallspäne 1 sowie Wasserglas 2. Dabei dient das Wasserglas 2 als Klebstoff, das für eine Diffusionsverklebung mit den Oxidschichten der Metallspäne 1 sorgt. Dabei können je nach späterem Verwendungszweck des Formteils 17 Metallspäne unterschiedlicher Metalle zum Einsatz kommen.

Die Metallspäne 1 können vor einer Vermischung mit dem Wasserglas 2 einem Zerkleinerer 4 zugeführt werden. In der Darstellung nach Fig. 1 ist dies durch den Pfeil 3 symbolisiert.

Die dem Zerkleinerer 4 entstammenden Metallspäne werden gemäß Pfeil 5 einem Mischer 9 zugeführt. In diesen Mischer 9 gelangt auch das Wasserglas 2 gemäß dem Pfeil 6. Innerhalb des Mischers 9 findet eine Vermischung der Ausgangsstoffe zur Herstellung des Kompositwerkstoffes statt.

Optional können dem Mischer 9 gemäß Pfeil 8 weitere Zuschlagstoffe 7 beigegeben werden, beispielsweise Graphit und/oder Metallpulver als hochwärmeleitendes Material.

Die im Mischer 9 zum Kompositwerkstoff zusammengemischten Ausgangsstoffe können optional sodann gemäß Pfeil 10 einem Homogenisierer 11 zugeführt werden. Hier findet eine gleichmäßige Verteilung aller Ausgangsstoffe innerhalb des Kompositwerkstoffes statt, was durch ergänzendes Vermahlen, Zerkleinern, Vermengen und/oder dgl. stattfinden kann.

Das den Homogenisierer 11 gemäß Pfeil 12 verlassende Material kann optional einem Sieb 13 zugeführt werden, so dass etwaige Verunreinigungen, Verklumpungen und/oder dgl. ungewollte Substanzen und/oder Agglomerationen aus dem Kompositwerkstoff entfernt werden können.

Es folgt sodann ein Weitertransport des Kompositwerkstoffes gemäß Pfeil 14 zu einer Presse 15. Im einfachsten Fall handelt es sich bei einer solchen Presse 15 um eine Flächenpresse, die zwischen ihren Pressstempeln eine Pressform zur Ausbildung von plattenförmigen Formteilen 17 bereitstellt. Es können aber auch Walzenpressen oder Kalanderpressen zum Einsatz kommen. Nach vollendetem Pressvorgang erfolgt eine Trocknung gemäß Pfeil 16 und als Verfahrensergebnis stehen erfindungsgemäße Formteile 17.

Es können alternativ auch in ihrer geometrischen Ausgestaltung kompliziertere Pressformen eingesetzt werden, was es gestattet, von der Plattenform abweichende Formteile 17 auszubilden.

### Bezugszeichenliste

- 1: Metallspäne
- 2: Wasserglas
- 3: Pfeil
- 4: Zerkleinerer
- 5: Pfeil
- 6: Pfeil
- 7: Zuschlagstoff
- 8: Pfeil
- 9: Mischer
- 10: Pfeil
- 11: Homogenisierer
- 12: Pfeil
- 13: Sieb
- 14: Pfeil
- 15: Presse
- 16: Pfeil
- 17: Formteil

## Patentansprüche

1. Verfahren zur Herstellung eines Formteils (17), insbesondere eines plattenförmigen Formteils (17), aus einem Kompositwerkstoff, bei dem in einem ersten Schritt der Kompositwerkstoff hergestellt wird, indem als Ausgangskomponenten Metallspäne (1) und Wasserglas (2) in einem vorgebbaren Mischungsverhältnis miteinander vermischt werden, bei dem in einem zweiten Schritt der Kompositwerkstoff in eine Pressform eingebracht und in einem dritten Schritt verpresst wird, **dadurch gekennzeichnet, dass** in den Kompositwerkstoff während des Verpressens ein Rohrregister eingepresst wird.

2. Verfahren nach Anspruch 1, **dadurch gekennzeichnet, dass** als Metallspäne Späne unterschiedlicher Metalle verwendet werden.

3. Verfahren nach Anspruch 1 oder 2, **dadurch gekennzeichnet, dass** der Kompositwerkstoff unter Verwendung eines Zuschlagstoffes als weitere Ausgangskomponente hergestellt wird.

4. Verfahren nach Anspruch 3, **dadurch gekennzeichnet, dass** der Kompositwerkstoff unter Verwendung eines hochwärmeleitenden Materials, vorzugsweise Graphit und/oder Metallpulver als weitere Ausgangskomponente hergestellt wird.

5. Verfahren nach einem der vorhergehenden Ansprüche, **dadurch gekennzeichnet, dass** die Metallspäne (1) vor einer Herstellung des Kompositwerkstoffes zerkleinert werden.

6. Verfahren nach einem der vorhergehenden Ansprüche, **dadurch gekennzeichnet, dass** der Kompositwerkstoff vor einer Verpressung homogenisiert wird.

7. Verfahren nach einem der vorhergehenden Ansprüche, **dadurch gekennzeichnet, dass** in den Kompositwerkstoff während des Verpressens Vertiefungen eingepresst werden.

8. Formteil, insbesondere plattenförmiges Formteil, hergestellt aus einem Kompositwerkstoff durch Verpressen, wobei der Kompositwerkstoff als Ausgangskomponenten Metallspäne (1) und Wasserglas (2) aufweist, **gekennzeichnet durch** ein Rohrregister, das in den Kompositwerkstoff eingepresst ist.

9. Formteil nach Anspruch 8, **dadurch gekennzeichnet, dass** der Kompositwerkstoff als weitere Ausgangskomponente ein hochwärmeleitendes Material, vorzugsweise Graphit und/oder Metallpulver aufweist.

10. Formteil nach einem der vorhergehenden Ansprüche 8 oder 9, **gekennzeichnet durch** eine Vertiefung, die in den Kompositwerkstoff eingepresst ist.

11. Verwendung eines Formteils (17) nach einem der vorhergehenden Ansprüche 8 bis 10 als Heiz- oder Kühlkörper.

## Claims

1. A method for the manufacture of a moulded part (17), in particular a plate-shaped moulded part (17), made of a composite material, in which in a first step the composite material will be produced by mixing metal shavings (1) and water glass (2) as starting components with each other in a pre-determinable mixing ratio, and in which in a second step the composite material will be introduced into a press mould and pressed in a third step, **characterized in that** a pipe register will be pressed into the composite material during the pressing step.

2. A method according to claim 1, **characterized in that** shavings of different metals will be used as metal shavings.

3. A method according to claim 1 or 2, **characterized in that** the composite material will be produced using an aggregate as another starting component.

4. A method according to claim 3, **characterized in that** the composite material will be produced using a high heat-conductive material, preferably graphite and/or metal powder as another starting component.

5. A method according to one of the preceding claims, **characterized in that** the metal shavings (1) will be crushed before the composite material is produced.

6. A method according to one of the preceding claims, **characterized in that** the composite material will be homogenized before being pressed.

7. A method according to one of the preceding claims, **characterized in that** depressions will be formed in the composite material during the step of pressing.

8. A moulded part, in particular a plate-shaped moulded part, manufactured from a composite material by pressing, wherein the composite material comprises metal shavings (1) and water glass (2) as starting components, **characterized by** a pipe register which is pressed into the composite material.

9. A moulded part according to claim 8, **characterized in that** the composite material comprises a high heat-conductive material, preferably graphite and/or metal powder as another starting component..

10. A moulded part according to one of the preceding claims 8 or 9, **characterized by** a depression which is pressed into the composite material.

11. A use of a moulded part (17) according to one of the preceding claims 8 through 10 as radiator or heat sink.

## Revendications

1. Procédé de fabrication d'une pièce moulée (17), notamment d'une pièce moulée en forme de plaque (17), à partir d'un matériau composite, dans lequel dans une première étape le matériau composite est produit en mélangeant des copeaux de métal (1) et du verre soluble (2) en tant que composants initiaux dans un rapport de mélange pré-déterminable, et dans lequel dans une deuxième étape le matériau composite est introduit dans un moule de pressage et pressé dans une troisième étape, **caractérisé en ce qu'**un registre de tuyaux est pressé dans le matériau composite pendant le pressage.

2. Procédé selon la revendication 1, **caractérisé en ce que** des copeaux de métaux différents sont utilisés en tant que copeaux de métal.

3. Procédé selon la revendication 1 ou la revendication 2, **caractérisé en ce que** le matériau composite est produit en utilisant un additif comme un autre composant initial.

4. Procédé selon la revendication 3, **caractérisé en ce que** le matériau composite est produit en utilisant un matériau à haute conductibilité thermique, de préférence du graphite et/ou poudre métallique comme un autre composant initial.

5. Procédé selon l'une des revendications précédentes, **caractérisé en ce que** les copeaux de métal (1) sont broyés avant une production du matériau composite.

6. Procédé selon l'une des revendications précédentes, **caractérisé en ce que** le matériau composite est homogénéisé avant un pressage.

7. Procédé selon l'une des revendications précédentes, **caractérisé en ce que** des cavités sont pressées dans le matériau composite au cours du pressage.

8. Pièce moulée, notamment pièce moulée en forme de plaque, fabriquée à partir d'un matériau composite par pressage, le matériau composite comprenant des copeaux de métal (1) et du verre soluble (2) en tant que composants initiaux, **caractérisé par** un registre de tuyaux qui est pressé dans le matériau composite.

9. Pièce moulée selon la revendication 8, **caractérisée en ce que** le matériau composite comprend un matériau à haute conductibilité thermique, de préférence du graphite et/ou poudre métallique, comme un autre composant initial.

10. Pièce moulée selon l'une des revendications précédentes 8 ou 9, **caractérisée par** une cavité pressée dans le matériau composite.

11. Utilisation d'une pièce moulée (17) selon l'une des revendications précédentes 8 à 10 en tant que radiateur ou dissipateur de chaleur.
